# EUROPEAN PATENT APPLICATION

(11) **EP 1 432 296 A1**
(43) Date of publication of application: **23.06.2004**
(21) Application number: 02360349.1
(22) Date of filing: 16.12.2002
(51) Int. Cl.: H05K 7/20

(54) **A device comprising an electric or electronic component**

(71) Applicant: Evolium S.A.S., 75008 Paris (FR)
(72) Inventor: Weese, Kurt, Dipl.-Ing., 71254 Ditzingen (DE)
(74) Representative: Dreiss, Fuhlendorf, Steimle & Becker

(57) **Abstract**

A device is described comprising an electric or electronic component (A, B) and a housing (D). The component (A, B) is arranged within the housing and the housing is able to act as a heat sink. A heat pipe (E) is provided extending between the component (A) and the housing (D). A thermally insulating material (C) is provided between the component (A) and the housing (D) such that the heat pipe (E) is the only thermal connection between the component (A) and the housing (D).

## Description

The invention relates to a device comprising an electric or electronic component and a housing, the component being arranged within the housing and the housing being able to act as a heat sink, and further comprising a heat pipe extending between the component and the housing.

Such a device is known from EP 946 085 A1. There, the heat pipes are used in connection with components which generate large amounts of heat so that the heat pipes can provide additional cooling reducing local hot spots.

However, if the device is used outdoor it is possible that at least some of the components have to be heated up to a required operating temperature, i.e. above a minimum temperature. During such heating, the good cooling capability of EP 946 085 A1 is a disadvantage as it increases the necessary power consumption and time duration for heating up these components.

It is an object of the invention to provide a device comprising an electric or electronic component which allows an efficient cooling as well as an efficient heating of the component.

This object is solved by the invention with an insulating material which is provided between the component and the housing such that the heat pipe is the only thermal connection between the component and the housing.

On one hand, the thermally insulating material ensures an efficient heating of the component. During the heating of the component, almost no heat flows is able to flow away. Instead, the insulating material concentrates the heating on the component. The heating, therefore, may be carried out fast and with little power consumption.

On the other hand, the heat pipe ensures that during normal conditions, in particular during normal operation of the component, the heat produced by the component can flow away via the heat pipe to the housing. The housing, therefore, acts as a heat sink for the component with the heat pipe being the carrier of the heat to the housing. Due to the heat pipe, the heat is able to pass the insulating material so that the component is cooled. Therefore, the heat pipe ensures an efficient cooling of the component.

Summarized, the insulating material in connection with the heat pipe provide a device with both, an efficient cooling and an efficient heating of a component within the device.

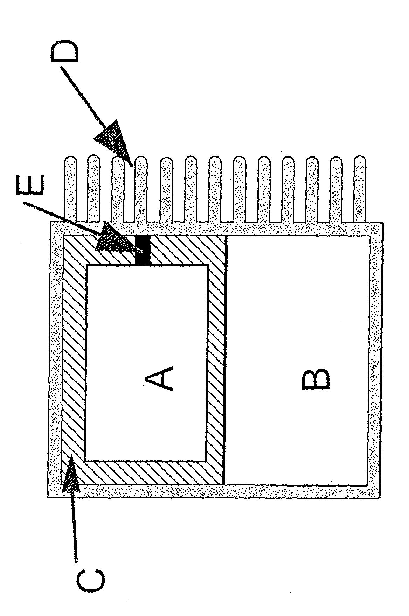

The present invention will become more readily apparent from the following detailed description of a preferred embodiment of the invention taken in conjunction with the accompanying drawing.

The only figure of the drawing shows a cross-sectional view of an embodiment of an electronic device according to the present invention.

The so-called Global System for Mobile Communications (GSM) is built up of a number of radio access networks. Each radio access network comprises at least a base transceiver station and a mobile station. In particular the base transceiver station is equipped with a number of devices each of them being located within a housing. Furthermore, it is possible that the base transceiver station and therefore its devices are constructed for outdoor use.

Such a device is shown in the figure. The device comprises two electric or electronic components A, B. Both components A, B produce heat when they are operating under normal operating conditions. Therefore, both components A, B have to be cooled so that the temperature of the components A, B does not increase above a maximum temperature. Furthermore, the component A requires a minimum temperature for operating properly so that it has to be heated if the temperature of the device becomes lower than this minimum temperature. In particular, such heating is necessary under startup conditions of the component A.

The component A is surrounded by an insulating material C which has thermal insulating characteristics. The insulating material C is surrounding the component A totally. It may be in contact with some of the outer surfaces of the component A but it must not. The thermally insulating material C avoids that heat flows away from the component A. Therefore, when the temperature of the device is below the minimum temperature and when the component A is heated e.g. by a heating element inside of the component A, the insulating material C avoids that the heat of the heating element flows away from the component A. As a result, the component A is heated up faster than without the insulating material C. The insulating material C, on one hand, serves for an efficient heating of the component A. However, on the other hand, the insulating material C is a problem for an efficient cooling of the component A as the insulating material C avoids that the heat flows away from the component A.

The insulating material C with the encapsulated component A is arranged within a housing D. The insulating material C, therefore, is arranged between the component A and the housing D. Some of the outer surfaces of the insulating material C may be in contact with the inner surfaces of the housing D but this must not be necessarily the case.

The housing D is provided with a number of radiator fins for cooling purposes. The housing D, therefore, is able to act as a heat sink.

A heat pipe E is provided. The heat pipe E has a tubular form and is the only thermal connection between the component A and the housing D. The heat pipe E extends between one of the outer surfaces of the component A and one of the inner surfaces of the housing D. The heat pipe E, therefore, traverses the insulating material C. The heat pipe E is in contact with the component A and the housing D. The heat pipe E, therefore, is able to transport heat from the component A to the housing D.

The heat pipe E is a known physical component that is able to transfer heat from one point to another. The heat pipe E, therefore, can maintain a constant temperature or a temperature range of the component A. An example of a heat pipe is described in US 5,335,720.

The component B is located within the housing D. The outer surfaces of the component B are in thermal contact with the inner surfaces of the housing D. Therefore, the heat produced under normal operating conditions by the component B can flow away directly to the housing D so that the component B is cooled.

It is now assumed that the components A, B are turned on after they had not been used for some time so that the temperature in particular of the component A is under the minimum temperature. Furthermore, it is assumed that the heat pipe E is provided such that it maintains a constant temperature within a temperature range which is defined by the mentioned minimum and maximum temperature.

Then, after starting, the component A is heated as described. Due to the insulating material C, the heat produced by heating the component A is held within the component A and cannot flow away. The heat pipe E from the component A to the housing D is not yet active or is only active to a very low extent as long as the temperature of the component A is still under the minimum temperature of the temperature range of the heat pipe E. Therefore, almost no heat can flow over the heat pipe E from the component A to the housing D. As a result, the component A is heated up quickly.

As soon as the temperature of the component A increases above the minimum temperature, the heat pipe E begins to transfer heat from the component A to the housing D. With the help of this heat flow, the heat pipe E maintains the temperature of the component A within the minimum and the maximum temperature. As a result, the cooling of the component A is carried out via the heat pipe E to the housing D.

At the same time, the component B is cooled directly by the housing D.

## Claims

1. A device comprising an electric or electronic component (A, B) and a housing (D), the component (A, B) being arranged within the housing and the housing being able to act as a heat sink, and further comprising a heat pipe (E) extending between the component (A) and the housing (D), **characterized in that** a thermally insulating material (C) is provided between the component (A) and the housing (D) such that the heat pipe (E) is the only thermal connection between the component (A) and the housing (D).

2. The device of claim 1 wherein the component (A) is surrounded by the insulating material (C) and wherein the heat pipe (E) traverses the insulating material (C).

3. The device of claim 1 wherein the heat pipe (E) is in thermal contact with the component (A) and the housing (D).

4. The device of claim 1 further comprising a heating element in particular within the component (A) for heating the component (A).

5. The device of claim 1, the housing (D) further comprising a number of radiator fins.

6. The device of claim 1 being incorporated within a radio access network, in particular within a base transceiver station of a radio access network.

7. A base transceiver station of a radio access network comprising a device according to one of claims 1 to S.
